# DEMANDE DE BREVET EUROPEEN

(11) **EP 1 241 279 A1**
(43) Date de publication de la demande: **18.09.2002**
(21) Numéro de dépôt: 02290607.7
(22) Date de dépôt: 11.03.2002
(51) Int. Cl.: C23C 18/16

(54) **Procédé de métallisation d'une pièce substrat**

(30) Priorité: 15.03.2001 FR 0103718
(71) Demandeur: Nexans, 75008 Paris (FR)
(72) Inventeur: Belouet, Christian, 92330 Sceaux (FR); Joly, Bertrand, 92310 Sevres (FR); Lecomte, Didier, 84300 Cavaillon (FR); Laurens, Patricia, 75013 Paris (FR)
(74) Mandataire: Lenne, Laurence

(57) **Abrégé**

La présente invention concerne un procédé de métallisation d'une pièce substrat, comprenant trois étapes successives qui sont :
- une étape de revêtement de la pièce par une couche de matériau composite précurseur, constitué d'une matrice polymère dopée de particules diélectriques en matériau photoréducteur,
- une étape consistant en une irradiation de la surface à métalliser de la pièce substrat par un faisceau de lumière émis par un laser,
- une étape consistant en une immersion de la pièce irradiée dans un bain autocatalytique contenant des ions métalliques, avec dépôt de ceux-ci en une couche sur la surface irradiée.

Selon l'invention, la dimension des particules diélectriques est inférieure ou égal à 0,5 microns.

Ce procédé est en particulier destiné à réaliser une pièce métallisée comprenant une pièce substrat constituée d'un film souple.

## Description

La présente invention se rapporte à un procédé de métallisation d'une pièce substrat.

Les pièces métallisées, en particulier polymères, sont utilisées dans de nombreux produits. Entre autres, le produit obtenu peut être utilisé dans les PCBs, les connecteurs, les antennes imprimées destinées à l'industrie automobile, les cartes à puces, les téléphones mobiles, etc.

Plusieurs procédés de métallisation sont connus.

Certains comportent plusieurs étapes par lesquelles l'adhésion sur la surface de la pièce substrat en matière plastique polymère est obtenue, souvent de façon empirique, par traitement thermique, par attaque chimique, par exposition plasma, par irradiation par faisceau ionique de faible énergie ou par radiation laser UV pulsé de haute énergie. En second lieu, un complexe est déposé sur la surface traitée. Ce complexe, constitué par exemple d'une résine polymère soluble dans l'eau chargée d'un sel d'un métal catalyseur, par exemple du palladium, imprègne la surface. Ce complexe est activé préalablement à l'étape de métallisation, grâce à un procédé photochimique ou thermique, qui réduit le métal catalyseur sous sa forme métal. Finalement, la métallisation au cuivre peut être réalisée par un dépôt autocatalytique, éventuellement complété par un dépôt électrolytique pour les fortes épaisseurs (typiquement supérieures à plusieurs microns).

Ces procédés posent plusieurs problèmes, en particulier, l'étape de dépôt d'un précurseur catalytique au palladium pour réaliser une bonne adhésion est particulièrement coûteuse.

L'invention, quant à elle, concerne un procédé de métallisation d'une pièce substrat, comprenant au moins deux étapes successives dont :
- une étape consiste en une irradiation de la surface à métalliser de la pièce substrat par un faisceau de lumière émis par un laser et,
- une étape ultérieure consiste en une immersion de la pièce irradiée dans au moins un bain autocatalytique contenant des ions métalliques, avec dépôt de ceux-ci en une couche sur la surface irradiée.

Un procédé de ce type est connu du brevet EP-0 693 138 qui décrit un procédé de métallisation de type positif d'une pièce substrat de matériau plastique composite contenant un copolymère et des grains d'un ou plusieurs oxydes métalliques, comprenant trois étapes successives dont la première consiste en une irradiation de la surface à métalliser de la pièce substrat par un faisceau de lumière émis par un laser excimère, la seconde consiste en l'immersion de la pièce irradiée dans au moins un bain autocatalytique contenant des ions métalliques et sans apport préalable de palladium, avec dépôt de ceux-ci en une couche sur la surface irradiée et la troisième étape consistant en un traitement thermique de la pièce métallique métallisée, de façon à obtenir une diffusion du métal déposé dans le matériau composite.

Ce procédé nécessite l'incorporation dans la masse de la matière plastique formée d'un polymère d'une substance minérale dispersée dans la matière plastique et formée de grains d'oxyde, par exemple oxydes d'antimoine, d'aluminium, de fer, de zinc et d'étain, notamment en concentration volumique supérieure à 1% et de taille variable, mais de préférence de taille supérieure à 0,5µm et n'excédant pas 50µm. Ces oxydes sont de plus diffusés dans le matériau plastique par le traitement thermique final. En effet, l'adhérence résultante est accrue en faisant diffuser le métal vers l'intérieur du composite en utilisant le chauffage sélectif et de courte durée de la couche métallique procuré par un four à micro-ondes.

Cet apport de substances minérales dans le polymère modifie les propriétés propres du polymère, ce qui est préjudiciable, car le volume du polymère est optimisé pour l'application.

Pour résoudre ce problème, il peut être envisagé de prévoir, préalablement à la première étape, une étape de révêtement de la pièce par une couche de matériau composite précurseur constitué d'une matrice polymère dopée de particules diélectriques en matériau photoréducteur.

Un tel procédé est connu des brevets US 4 426 442 et US 4 853 252.

Selon ces brevets, la pièce est préalablement revêtue d'une couche de matériau photoréducteur. Cette couche est constituée d'une matrice polymère dopée de particules diélectriques, plus précisément de dioxyde de titane.

Selon les procédés décrits, il n'est pas considéré de dimension précise de ces particules et la couche peut atteindre 10 microns d'épaisseur.

Par dimension de particule, il est entendu le diamètre moyen de ces particules.

Or, il s'avère que lorsque ces particules sont de dimension relativement importante, les problèmes techniques suivants se présentent.

Tout d'abord, à fraction volumique constante des particules dans la matrice polymère, les forces d'ahésion effectives des ions métalliques ultérieurement déposés sont moindres lorsque la taille des particules croît. Il est donc nécessaire d'utiliser des fractions volumiques importantes pour obtenir une bonne tenue de la métallisation, ce qui entraîne un coût de matériau important et limite les possibilités de choix du polymère, selon les compatibilités du polymère avec les particules.

De plus, afin d'obtenir un dépôt uniforme d'ions métalliques de métallisation, il est nécessaire de déposer une épaisseur relativement importante d'ions métalliques. Ceci est également particulièrement coûteux en matériau et de plus l'on obtient un dépôt relativement rugueux.

Enfin, la résolution latérale d'une zone ainsi métallisée est mauvaise. Par résolution latérale, il est entendu la régularité d'une bordure d'une telle zone.

Ceci est préjudiciable à l'obtention de zones précises métallisées, telles que des pistes de circuits intégrés, de bonne qualité et économiquement rentable.

L'invention résout ces problèmes et pour ce faire propose un procédé de métallisation d'une pièce substrat, comprenant trois étapes successives qui sont :
- une étape de revêtement de la pièce par une couche de matériau composite précurseur, constitué d'une matrice polymère dopée de particules diélectriques en matériau photoréducteur,
- une étape consistant en une irradiation de la surface à métalliser de la pièce substrat par un faisceau de lumière émis par un laser,
- une étape consistant en une immersion de la pièce irradiée dans un bain autocatalytique contenant des ions métalliques, avec dépôt de ceux-ci en une couche sur la surface irradiée,
caractérisé en ce que la dimension desdites particules diélectriques est inférieure ou égale à 0,5 microns.

La pièce substrat de matière plastique peut être constituée d'un polymère dopé ou non, par exemple pur non chargé de grains d'oxydes, ainsi que dans le cas des substrats non polymères, tels que des céramiques, en particulier les céramiques dont la surface ne peut pas être facilement photoréduite par irradiation laser UV, des verres et des semi-conducteurs entre autres.

Ce procédé peut s'appliquer à toutes formes de pièces, plates ou cylindriques par exemple.

De plus, la préparation d'un tel matériau composite peut exploiter le développement rapide de la technologie des polymères dopés par des nanoparticules et en particulier la liaison chimique des nanoparticules avec une matrice polymère au moyen de ligands moléculaires.

La matrice polymère est réalisée en matériau sélectionné pour obtenir une bonne adhérence à son interface avec la pièce substrat. Son choix dépend donc de la matière de la pièce substrat. De préférence, des matériaux du type polyéthylène, polypropylène, polycarbonate ou polyimide sont utilisés.

Avantageusement, lesdites particules diélectriques sont en matériau photoréducteur, et de préférence, lesdites particules diélectriques sont des oxydes choisis parmi ZnO, TiO₂, ZrO₂, Al₂O₃ ou CeO₂.

Avantageusement, ladite couche de matériau composite a une épaisseur d'au plus un micron, cette épaisseur pouvant être inférieure dans le cas où la taille des particules d'oxydes est nanométrique.

Ladite couche de matériau composite peut être appliquée selon des techniques classiques, telles que dépôt à la tournette, par dispersion, par revêtement par immersion, par sérigraphie, par projection ou par extrusion dans le cas d'une pièce substrat en forme de câble.

Selon un mode de réalisation préféré, dans le cas d'une pièce substrat en matériau plastique polymère, ladite couche de matériau composite est appliquée sur la pièce substrat par plaquage laser, lesdites particules diélectriques étant déposées sur la surface de la pièce substrat en matière plastique polymère préalablement au chauffage par laser selon une technique de dispersion ou étant injectées au moyen d'une buse durant le chauffage par laser.

Ceci est un exemple de réalisation. Il est entendu que, même dans le cas d'une pièce substrat polymère, il peut être envisagé de revêtir cette pèce d'une couche de matériau composite au lieu d'enrober, comme décrit plus haut, la poudre d'oxydes à la surface de la pièce substrat.

Après dépôt de la couche de matériau composite, selon la deuxième étape du procédé, cette couche est irradiée par un faisceau laser UV pulsé. Cette étape vise à activer la surface des petites particules diélectriques, mises à nu par l'ablation simultanée du polymère d'enrobage, pour le dépôt autocatalytique ultérieur de métal, par exemple de cuivre. Cette opération peut se faire de deux façons différentes : irradiation de toute la surface de la pièce ou irradiation au travers d'un masque de projection afin de n'activer que la surface à métalliser.

Si le dépôt du composite est fait par sérigraphie, les pistes futures sont déjà tracées. On peut alors irradier toute la surface de la pièce substrat, car seules les pistes seront activées pour le dépôt autocatalytique ultérieur.

L'utilisation de nanoparticuies diélectriques présente plusieurs avantages. L'on obtient des surfaces tès lisses avec une résolution latérale élevée. Il est également obtenu de grandes valeurs de recouvrement de surface de l'aire diélectrique activée, ce qui permet l'obtention d'une métallisation selon un film homogène et une adhérence de plus de 1 Kg/mm². Par exemple, dans le cas de particules de ZnO de diamètre 100 nm, le recouvrement de surface par la surface activée peut approcher 50% pour une fraction volumique de nanoparticules n'excédant pas 10%.

L'emploi de masque de projection lors de l'irradiation laser permet d'éviter l'application d'une étape photolithographique afin de délimiter la zone de métallisation, en cas de métallisation partielle. A cet égard, le procédé est compatible avec des changements de niveaux entre deux surfaces du produit à métalliser.

La troisième étape du procédé comporte un dépôt autocatalytique de métal, de préférence de cuivre, par immersion de la pièce dans un bain autocatalytique, comme effectué dans l'art antérieur cité dans le préambule de la description. Dans le cas d'une métallisation partielle, à partir d'une surface entièrement couverte, une étape photolithographique est alors nécessaire, entre l'irradiation laser et l'immersion dans le bain autocatalytique, pour délimiter les surfaces à métalliser.

Après le dépôt autocatalytique, qui conduit à une épaisseur d'au plus quelques microns, on peut compléter le film par un dépôt électrolytique par des procédés connus. Ce dépôt est plus rapide et moins couteux que le dépôt autocatalytique, indispensable uniquement dans une phase initiale permettant d'obtenir une bonne adhésion à la surface de l'oxyde et la réalisation d'un film continu. Egalement, on peut renforcer le dépôt autocatalytique par un autre procédé, par exemple par dépôt d'étain à la vague.

Ce nouveau procédé permet de séparer l'optimisation des propriétés de la pièce substrat de matériau plastique polymère d'une part et des constituants de la métallisation d'autre part. Le polymère utilisé pour la métallisation lors de la première étape peut différer de celui de la pièce substrat. Par exemple, il est possible de sélectionner pour la métallisation un matériau polymère qui a une absorption assez élevée à la longueur d'onde de 248 nm, qui est la longueur d'onde des lasers excimères du commerce les plus courants.

Un premier exemple de réalisation du procédé est décrit ci-après en détail.

Selon la première étape, une couche de matériau composite de polymère chargé d'oxyde de zinc ZnO est appliquée par plaquage laser sur une pièce substrat de matériau polymère, par exemple du polycarbonate. Ceci est réalisé par déplacement de la surface polymère à une vitesse constante d'environ 10 à 100 mm/s sous le faisceau laser continu, de préférence un laser CO₂. La puissance du laser est sélectionnée dans une fourchette de plusieurs dizaines à plusieurs centaines de Watts, de façon à chauffer la surface polymère et de permettre l'enrobage des particules de céramiques sous la surface du polymère rendue visqueuse. La poudre de céramique est déposée sur la surface polymère préalablement au chauffage par laser selon une technique de dispersion classique ou est injectée durant le chauffage par laser au moyen d'une buse. Par cette technique, les particules de ZnO d'une dimension de 0,5 microns sont noyées dans la surface traitée de polymère. L'épaisseur et la composition de la couche composite peuvent être réglées par variation des paramètres du laser, c'est-à-dire par sa puissance et sa vitesse de balayage.

Selon la seconde étape du procédé, la couche composite est activée par un laser excimère pulsé UV ( de longueur d'onde de 193 nm). Cette opération est réalisée avec les paramètres laser suivants : 50 à 200 impulsions à une fluence proche de 500 mJ /cm².

Un dépôt autocatalytique de cuivre est alors réalisé selon la troisième étape du procédé. La métallisation n'est réalisée que sur les zones traitées par laser. Une adhérence de 1,4 kg/mm² est ainsi obtenue au niveau de la métallisation au cuivre. Cette adhérence peut être mesurée par test de traction standard. Les tests de traction sont réalisés après fixation par collage de clous métalliques (diamètre de 2 mm) sur les pistes de cuivre à tester. Ces clous sont tirés perpendiculairement à l'échantillon sous une force croissante jusqu'à séparation, de façon à déterminer l'adhérence.

Un second exemple de réalisation du procédé est décrit ci-après en détail.

Selon la première étape, une couche de matériau composite de polymère chargé de particules d'oxyde de zinc ZnO de diamètre moyen inférieur ou égal à 0,5 microns est appliquée sur une pièce substrat de matériau polymère par procédé à la tournette à une rotation de 500 à 2000 tours/mn.

La pièce substrat est une plaque de polycarbonate ou de silicium d'une épaisseur de 500µm.

La matrice polymère est du poly[bisphénol A carbonate-co-4,4'-(3,3,5-trimethylcyclohexylidene) diphenol carbonate] et le matériau composite est contenu dans un solvant, de préférence du 1,2 dichloroéthane.

Des agents dispersants usuels sont ajoutés à ce matériau précurseur.

Selon la seconde étape du procédé, la couche composite est activée par un laser excimère pulsé UV ( de longueur d'onde de 193 nm). Cette opération est réalisée avec les paramètres laser suivants : 1 à 5 impulsions à une fluence proche de 500 mJ /cm².

Un dépôt autocatalytique de cuivre est alors réalisé selon la troisième étape du procédé.

De plus, l'invention concerne une pièce métallisée grâce à la mise en oeuvre du procédé précédemment décrit, comprenant une pièce substrat constituée d'un film souple.

Avantageusement, ledit film est constitué d'une matière plastique et en particulier d'un polymère, de préférence du polyéthylène ou du polyimide.

Outre la résolution des problèmes techniques déjà précisés, l'invention permet la réalisation d'un film fin de matière plastique métallisé, dont l'épaisseur est particulièrement petite. Ce type de film peut trouver en autre son application dans la réalisation de métallisation de zones de substrat de forme complexe. En effet, dans de telles zones, il peut s'avérer très complexe ou même impossible de réaliser un traitement direct de métallisation conforme à l'invention. Par exemple, il peut s'avérer difficile de réaliser une irradiation laser dans des formes en creux où est souhaitée une métallisation par le procédé conforme à l'invention sur toute la surface du creux. Grâce à l'invention, dans de tels cas, le film métallisé est déposé, par exemple, par collage, sur la surface.

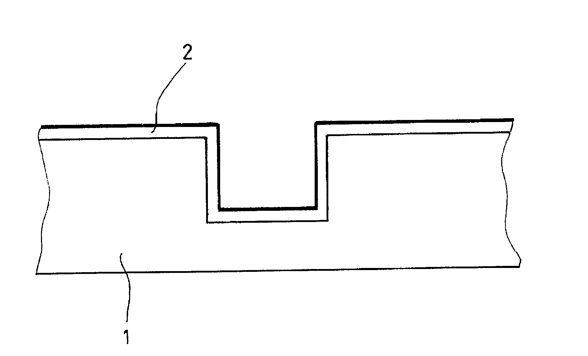

Une telle pièce métallisée posée sur un support est représentée sur la figure qui est une vue latérale de ce support.

Le support 1 est une carte, par exemple en époxy ou en polycarbonate renforcé par des fibres de verre, présentant une rainure réalisée sur sa face supérieure. Afin de réaliser une piste conductrice sur cette carte et à l'intérieur de la rainure, un film 2 métallisé grâce à la mise en oeuvre du procédé conforme à l'invention est fixé sur la surface de la carte, par exemple par collage.

il est à noter que l'on peut réaliser le dépôt des ions métalliques sur la surface irradiée du film rapporté soit avant soit après collage de ce dernier. Selon les courbures, on peut avoir avantage à le faire après. Ceci est possible, car la zone irradiée par le laser reste active longtemps après l'irradiation. Expérimentalement, il a été observé que cette activation durait plusieurs mois après irradiation.

Un troisième exemple de réalisation du procédé, relatif plus précisément à la fabrication d'un tel film métallisé, est décrit ci-après en détail.

Un film est extrudé en polyéthylène, polyimide ou Mylar par exemple de 50 microns d'épaisseur. Plus généralement, une épaisseur de 10 microns à 1 mm peut être envisagée. Ce film est passé en continu et en série dans un bac de déposition du matériau composite précurseur puis dans une étuve de séchage suivi d'un chauffage par exemple par irradiation laser CO2 puis de l'irradiation par un laser excimère d'activation. Un passage au bain autocatalytique peut se faire à vitesse lente ou en statique jusqu'à l'obtention d'une épaisseur de métal de 0,5 à 10 microns d'épaisseur.

Un tel film composite laminé peut donc être fabriqué en continu.

Une métallisation sélective pouvant prendre la forme de surfaces complexes et de haute définition avec une précision de l'ordre du micron peut également être réalisée pour la réalisation de protection radioélectrique de type écrans ou la circuiterie électronique dans des applications de type circuit imprimé, circuit intégré, carte magnétique, carte à puce ...

Les films élémentaires sont alors traités en séquence dans la phase d'irradiation par laser excimère à travers un masque de facon à imprimer sur le film la forme exacte et précise de la métallisation souhaitée qui apparaîtra lors du passage au bain autocatalytique.

Il est également à noter que des applications à la fabrication de membranes sélectives, de films à usage décoratif ou destinés à l'imprimerie sont également envisageables selon le procédé conforme à l'invention.

## Revendications

1. Procédé de métallisation d'une pièce substrat, comprenant trois étapes successives qui sont :
- une étape de revêtement de la pièce par une couche de matériau composite précurseur, constitué d'une matrice polymère dopée de particules diélectriques en matériau photoréducteur,
- une étape consistant en une irradiation de la surface à métalliser de la pièce substrat par un faisceau de lumière émis par un laser,
- une étape consistant en une immersion de la pièce irradiée dans un bain autocatalytique contenant des ions métalliques, avec dépôt de ceux-ci en une couche sur la surface irradiée,
**caractérisé en ce que** la dimension desdites particules diélectriques est inférieure ou égale à 0,5 microns.

2. Procédé selon la revendication 1, **caractérisé en ce que** lesdites particules diélectriques sont des oxydes choisis parmi ZnO, TiO₂, ZrO₂, Al₂O₃ ou CeO₂.

3. Procédé selon l'une des revendications précédentes, **caractérisé en ce que** ladite couche de matériau composite a une épaisseur d'environ un micron.

4. Procédé selon l'une des revendications précédentes, **caractérisé en ce que** ladite étape ultérieure (B) est complétée par une étape de dépôt électrolytique.

5. Procédé selon l'une des revendications précédentes, **caractérisé en ce que** la pièce substrat est en matériau plastique polymère et ladite couche de matériau composite est appliquée sur la pièce substrat de matériau plastique polymère par plaquage laser.

6. Procédé selon la revendication 5, **caractérisé en ce que** lesdites particules diélectriques sont déposées sur la surface de la pièce substrat en matière plastique polymère préalablement au chauffage par laser selon une technique de dispersion.

7. Procédé selon la revendication 5, **caractérisé en ce que** lesdites particules diélectriques sont injectées au moyen d'une buse durant le chauffage par laser.

8. Pièce métallisée (2) grâce à la mise en oeuvre du procédé conforme à l'une des revendications précédentes, **caractérisé en ce qu'**elle comprend une pièce substrat constituée d'un film souple.

9. Pièce selon la revendication 8, **caractérisé en ce que** ledit film est constitué d'une matière plastique.

10. Pièce selon la revendication 9, **caractérisé en ce que** ledit film est constitué d'un polymère, de préférence du polyéthylène ou du polyimide.
